# EUROPEAN PATENT APPLICATION

(11) **EP 4 145 044 A1**
(43) Date of publication of application: **08.03.2023**
(21) Application number: 21797635.6
(22) Date of filing: 23.04.2021
(51) Int. Cl.: F21V 19/00, F21S 41/19, F21W 102/00, F21Y 115/10

(54) **SUBSTRATE SUPPORT BODY, SUBSTRATE SUPPORT STRUCTURE, LIGHT-EMITTING DEVICE, AND LAMP**

(30) Priority: 27.04.2020 JP 2020078378
(71) Applicant: Kyocera Corporation, Kyoto-shi Kyoto 612-8501 (JP)
(72) Inventor: MATSUMOTO, Yuhei, Kyoto-shi, Kyoto 612-8501 (JP); YAMAMOTO, Sentarou, Kyoto-shi, Kyoto 612-8501 (JP); OKAMOTO, Kazuhiro, Kyoto-shi, Kyoto 612-8501 (JP); OKAWA, Yoshihide, Kyoto-shi, Kyoto 612-8501 (JP)
(74) Representative: Viering, Jentschura & Partner mbB Patent- und Rechtsanwälte
(86) International application number: PCT/JP2021/016552
(87) International publication number: WO 2021/220995

(57) **Abstract**

A substrate support body (A1, B1, C1, or D1) includes a support plate (1), an enclosure member (3), and a bonding material (5). The enclosure member (3) is arranged on the support plate (1). The bonding material (5) is arranged on an entire surface of an inner region (3a) of the enclosure member (3) and is bonded to the support plate (1).

## Description

### TECHNICAL FIELD

The present disclosure relates to a substrate support body, a substrate support structure, a light emitting device and a lighting fixture.

### BACKGROUND OF INVENTION

In recent years, a Light Emitting Diode (LED) has been used in a headlamp of an automobile. In this case, a structure has been proposed in which a plurality of LEDs are mounted on a wiring substrate in order to increase the amount of light (see, for example, Patent Literature 1).

### CITATION LIST

### PATENT LITERATURE

### Patent Literature 1: JP 2015-103714 A

### SUMMARY

A substrate support body of the present disclosure includes a support plate, an enclosure member, and a bonding material. The enclosure member is arranged in a central region of the support plate. The bonding material is arranged on an entire surface of an inner region of the enclosure member and is bonded to the support plate.

### BRIEF DESCRIPTION OF THE DRAWINGS

FIG. 1 is an exploded perspective view of a substrate support structure according to an embodiment.
FIG. 2 is a plan view of the substrate support structure illustrated in FIG. 1.
FIG. 3 is a cross-sectional view taken along line iii-iii of FIG. 1.
FIG. 4 is a cross-sectional view illustrating another aspect of the substrate support structure.
FIG. 5 is a cross-sectional view illustrating another aspect of the substrate support structure.
FIG. 6 is a cross-sectional view illustrating another aspect of the substrate support structure.
FIG. 7 is a plan view of the substrate support structure illustrated in FIG. 6 as viewed from a direction facing a surface of the substrate support structure on which the element mounting substrate is arranged.
FIG. 8 is an exploded perspective view illustrating another aspect of the substrate support structure.
FIG. 9 is a plan view of the substrate support structure illustrated in FIG. 8.
FIG. 10 is a cross-sectional view taken along a line x-x in FIG. 8.
FIG. 11 is a cross-sectional view illustrating another aspect of the substrate support structure.
FIG. 12 is a cross-sectional view illustrating another aspect of the substrate support structure.
FIG. 13 is a cross-sectional view of a light emitting device illustrated as an example of the embodiment.
FIG. 14 is a cross-sectional view of a lighting fixture illustrated as an example of the embodiment.
FIG. 15 is a cross-sectional view illustrating a manufacturing method for a substrate support body illustrated as an example of the embodiment.
FIG. 16 is a cross-sectional view illustrating a state in which an enclosure member having a chevron cross-sectional shape is formed.
FIG. 17 is a cross-sectional view illustrating a method for determining the degree of parallelism of the substrate support structure.

### DESCRIPTION OF EMBODIMENTS

With respect to the light emitting device disclosed in Patent Literature 1, improvement is demanded for the heat dissipation from the substrate on which the light emitting element is mounted, as compared with a known case. The present applicant proposes a structure in which, when a substrate on which a plurality of light emitting elements are mounted is bonded to a support plate, the substrate bonded to the support plate can be arranged in a more stable state in addition to improving heat dissipation from the support plate. Hereinafter, the substrate is referred to as a substrate support body.

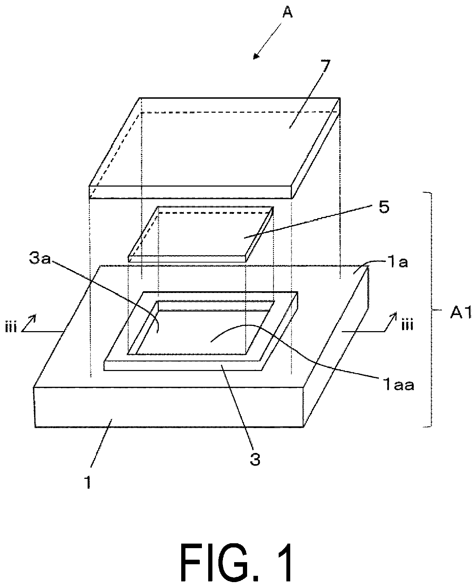

A substrate support structure and a light emitting device according to an embodiment will be described with reference to FIGs. 1 to 6. Note that an aspect of the present invention is not limited to the particular embodiment to be described below. The aspect of the present invention includes various aspects insofar as these aspects fall within the spirit or scope of the general concepts of the invention as defined by the appended claims.

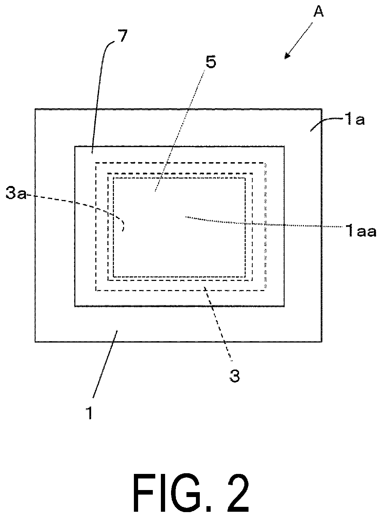

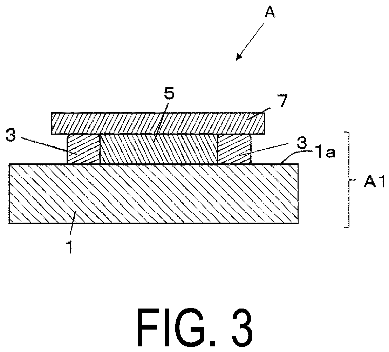

FIG. 1 is an exploded perspective view of the substrate support structure illustrated as an example of the embodiment. FIG. 2 is a plan view of the substrate support structure illustrated in FIG. 1. FIG. 3 is a cross-sectional view taken along line iii-iii of FIG. 1. In FIG. 2, an enclosure member 3 is a frame-like portion that is between two rectangular portions indicated by dashed lines.

A bonding material 5 is a rectangular portion indicated by a dotted line arranged inside the enclosure member 3. An element mounting substrate 7 is a solid rectangular portion larger than the enclosure member 3. FIG. 2 illustrates a state in which a gap is provided between the enclosure member 3 and the bonding material 5. Such an illustration is for ease of understanding of the enclosure member 3 and the bonding material 5 on the drawings.

A substrate support structure A illustrated as the example of the embodiment includes at least a support plate 1, the enclosure member 3, and the bonding material 5. In the substrate support structure A, a portion constituted by the support plate 1, the enclosure member 3, and the bonding material 5 is the substrate support body. In FIG. 1, a portion of the substrate support body is indicated by reference sign A1.

The support plate 1 is made of metal. The metal material includes a material containing one kind selected from aluminum, copper, brass and the like as a main component. The support plate 1 may be a clad material obtained by bonding an aluminum foil and a copper foil. The enclosure member 3 is made of an organic resin. The bonding material 5 is a low melting point metal represented by solder, Au-Sn, and silver solder.

The enclosure member 3 is arranged in a central region 1aa of the support plate 1. Here, the central region 1aa of the support plate 1 is the central region 1aa in a main surface 1a of the support plate 1, as illustrated in FIG. 2. The enclosure member 3 is in a state of protruding from the main surface 1a. The state of protruding from the main surface 1a means a state of protruding from a surface on which the enclosure member 3 is installed.

As illustrated in FIGs. 1 and 2, the enclosure member 3 may have a rectangular outer peripheral edge. The shape of the enclosure member 3 may not be rectangular depending on the application of the light emitting device to be described below. For example, the shape may be circular, elliptical, polygonal having more corners than a rectangular, or the like.

The shape of the enclosure member 3 is a shape in which the vicinity of the center of an inner region 3a of the enclosure member 3 is a centroid. The enclosure member 3 is line-symmetric in a planar shape. The bonding material 5 is arranged on an entire surface of the inner region 3a of the enclosure member 3.

A substrate support body A1 has a configuration in which the enclosure member 3 is arranged on the support plate 1 and the bonding material 5 is arranged on the entire surface of the inner region 3a of the enclosure member 3. Therefore, the surface area and the shape of the bonding material 5 can be fixed. In this manner, for example, the element mounting substrate 7 for mounting the light emitting element can be arranged on the bonding material 5 more parallel to the support plate 1 and stably at a predetermined position.

The stable arrangement at a predetermined position means that the element mounting substrate 7 can be arranged at a desired position on the support plate 1. A ceramic substrate is used as the element mounting substrate 7. In this case, a surface area of a main surface of the element mounting substrate 7 is greater than a surface area of a region surrounded by an outer peripheral edge of the enclosure member 3.

The ceramic substrate has a high thermal resistance, a high mechanical strength, and a property that its coefficient of thermal expansion is close to that of the material of the light emitting element to be described below. The material of the ceramic substrate is a material containing one kind selected from the group consisting of alumina, glass ceramics, silicon nitride, aluminum nitride, mullite, forsterite, enstatite and cordierite as a main component. Among them, silicon nitride is particularly preferable in terms of thermal resistance and mechanical strength.

On the surface of the element mounting substrate 7 to be bonded to the bonding material 5, a metallized film is formed in advance for the purpose of enhancing the wettability with the bonding material 5. The metallized film is a metallized film of copper. The metallized film of copper is preferably formed by plating films of nickel, gold, and tin in this order.

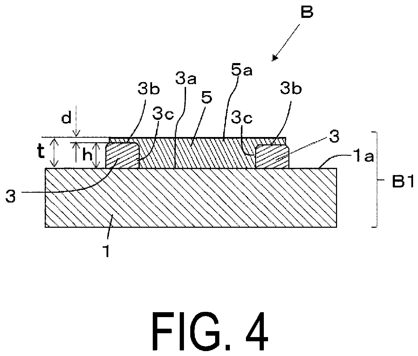

FIG. 4 is a cross-sectional view illustrating another aspect of the substrate support structure. In the case of a substrate support structure B illustrated in FIG. 4, because many reference signs are given in FIG. 4, the element mounting substrate 7 is omitted for convenience. Also in this case, it goes without saying that the element mounting substrate 7 is arranged as in the case of the substrate support structure A. In FIG. 4, a portion of the substrate support body is designated B1.

In the substrate support body B1 illustrated in FIG. 4, a height h of the enclosure member 3 and a thickness t of the bonding material 5 are different from each other. The upper surface of the enclosure member 3 is lower than the upper surface of the bonding material 5. In other words, the height h of the enclosure member 3 is less than the thickness t of the bonding material 5. As a result, when the element mounting substrate 7 is placed on the bonding material 5, the bonding material 5 tends to spread around the enclosure member 3 due to the applied pressure.

Therefore, according to the configuration of the substrate support body B1, the parallelism of the bonding material 5 can be enhanced. As illustrated in FIG. 4, the height h of the enclosure member 3 is a distance from the main surface 1a of the support plate 1 to an apex portion 3b of the enclosure member 3. In the case of the enclosure member 3 illustrated in FIG. 4, because the upper surface is flat, the apex portion 3b of the enclosure member 3 is a height up to the flat surface.

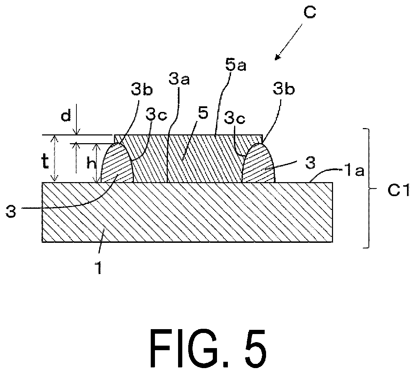

FIG. 5 is a cross-sectional view illustrating another aspect of the substrate support structure. FIG. 5 illustrates a substrate support structure C. Also in the case of the substrate support structure C illustrated in FIG. 5, because many reference signs are given in FIG. 5, the element mounting substrate 7 is omitted for convenience. Also in this case, it goes without saying that the element mounting substrate 7 is arranged as in the case of the substrate support structure A. In FIG. 5, a portion of the substrate support body is designated C1.

In the substrate support structure C, when the enclosure member 3 has a convex shape as illustrated in FIG. 5, the upper surface of the enclosure member 3 is an apex portion of the convex shape. As illustrated in FIG. 2, the enclosure member 3 is formed in a circling shape on the main surface 1a of the support plate 1. When the enclosure member 3 has a circling shape, the height h of the enclosure member 3 from the support plate 1 is lower than the position of the upper surface 5a of the bonding material 5 at a rate of 80% or more upon setting the total length of the circling length of the enclosure member 3 to 100.

When a relationship between the height h of the enclosure member 3 from the support plate 1 and the position of the upper surface 5a of the bonding material 5 is specifically measured, for example, one place is designated from each side of the enclosure member 3 to select a place to be measured. Then, a photograph of a cross section of the one place is taken, and the presence or absence of a difference between the height h of the enclosure member 3 from the support plate 1 and the position of the upper surface 5a of the bonding material 5 is evaluated from the taken photograph.

In this case, a difference d between the height h of the enclosure member 3 and the thickness t of the bonding material 5 is 30 µm or less. Here, the difference d is a dimensional difference. The difference d between the height h of the enclosure member 3 and the thickness t of the bonding material 5 corresponds to a difference d between the position of the apex portion 3b of the enclosure member 3 with respect to the main surface 1a of the support plate 1 and the position of the upper surface 5a of the bonding material 5.

When the difference d between the height h of the enclosure member 3 and the thickness t of the bonding material 5 is 30 µm or less, the amount of deformation when the bonding material 5 is pressurized can be reduced. In this case, the difference d between the height h of the enclosure member 3 and the thickness t of the bonding material 5 is 5 µm or more because the bonding material 5 easily spreads around the enclosure member 3 by pressurization and the filling rate of the bonding material 5 into the inner region 3a of the enclosure member 3 can be increased.

When the difference d between the height h of the enclosure member 3 and the thickness t of the bonding material 5 is determined, the height h of the enclosure member 3 and the thickness t of the bonding material 5 are measured from the photograph obtained by photographing the cross section of the enclosure member 3 as described above, and the difference d is determined from these values.

As illustrated in FIGs. 4 and 5, the bonding material 5 is in contact with a portion from a side surface 3c facing the inner region 3a of the enclosure member 3 to the apex portion 3b of the enclosure member 3. As a result, the bonding material 5 is easily spread in contact with the side surface 3c of the enclosure member 3 when the bonding material 5 spreads around the enclosure member 3 due to the pressure applied.

In a state where the bonding material 5 is in contact with a portion from the side surface 3c facing the inner region 3a of the enclosure member 3 to the apex portion 3b of the enclosure member 3, a friction force is likely to act between the side surface 3c as well as the apex portion 3b of the enclosure member 3 and the bonding material 5. This causes the speed of spread of the bonding material 5 to be slow. This also makes it easy to control the spreading speed and spreading area of the bonding material 5. As a result, the parallelism of the bonding material 5 with respect to the main surface 1a of the support plate 1 can be further enhanced.

As illustrated in FIG. 5, a portion of the enclosure member 3 from the side surface 3c facing the inner region 3a to the apex portion 3b forms a convex curved surface. In a structure in which the portion from the side surface 3c to the apex portion 3b of the enclosure member 3 has a shape forming a convex curved surface, the bonding material 5 easily spreads smoothly around the enclosure member 3 without resistance from the beginning due to the pressure applied, for example, as compared with the case where the portion from the side surface 3c to the apex portion 3b of the enclosure member 3 has a step.

This facilitates the control of the surface area of the spreading bonding material 5. This also makes it possible to make the surface area of the bonding material 5 spreading around the enclosure member 3 approximately the same in all directions. As a result, the parallelism between the upper surface 5a of the bonding material 5 and the main surface 1a of the support plate 1 can be enhanced. In this manner, the deviation of the heat dissipation due to the influence of the spread of the bonding material 5 can be reduced. In this case, as illustrated in FIG. 5, the enclosure member 3 has a chevron shape in cross section. In particular, the side surface 3c is in the form of a convexly bulging chevron.

The elastic modulus of the enclosure member 3 is less than the elastic modulus of the bonding material 5. Accordingly, even when the bonding material 5 is less likely to be deformed by the applied pressure, the enclosure member 3 is more likely to be deformed, and thus a crack is less likely to occur in the bonding material 5. As a result, a mechanically highly reliable substrate support structure can be obtained.

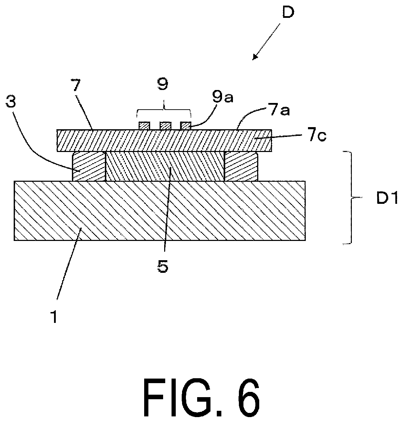

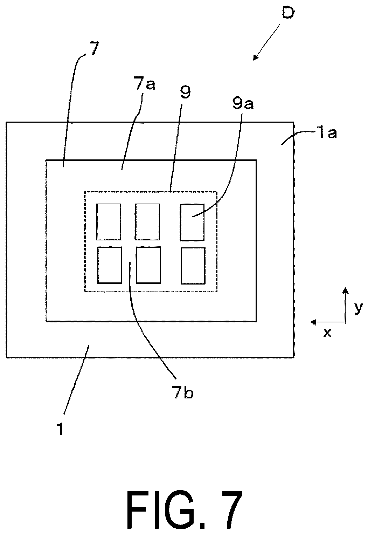

FIG. 6 is a cross-sectional view illustrating another aspect of the substrate support structure. FIG. 7 is a plan view of a substrate support structure D illustrated in FIG. 6 as viewed from a direction facing a surface of the substrate support structure D on which the element mounting substrate is arranged. In FIG. 6, a portion of the substrate support body is designated D1. In the substrate support structure D illustrated in FIGs. 6 and 7, the element mounting substrate 7 includes a mounting portion 9 for the light emitting element at an upper surface 7a of the element mounting substrate 7.

As illustrated in FIG. 7, the mounting portion 9 is arranged in a center portion 7b of the upper surface 7a of the element mounting substrate 7. Here, the center portion 7b of the element mounting substrate 7 is a region extending substantially uniformly from the position of the center (centroid) of the element mounting substrate 7 at a rate corresponding to the length of each side in the x direction and the y direction of the element mounting substrate 7. As a guide for the surface area of the center portion 7b is a surface area corresponding to the product of half the length of the side of the element mounting substrate 7 in the x direction and half the length of the side of the element mounting substrate 7 in the y direction.

The mounting portion 9 includes a plurality of terminals 9a. FIG. 7 illustrates a case where the number of terminals 9a is six, but the number of terminals is not limited to six. For example, the number of terminals 9a may be eight or more. The number of terminals 9a varies depending on the required output power of the light emitting device, the size of the support plate 1, and the like. However, in order to suppress the amount of heat generated from the light emitting device, the number of terminals 9a can be set to, for example, 100 or less. As illustrated in FIG. 7, the surface area of the mounting portion 9 on a surface (upper surface 7a) of the element mounting substrate 7 is less than the surface area of the bonding material 5 in a direction identical to a direction along the surface.

When the light emitting element is connected to each terminal 9a and driven, the region of the mounting portion 9 is present in the region of the bonding material 5. Therefore, the deviation of the heat dissipation caused by driving of a plurality of light emitting elements can be reduced. As a result, a light emitting device having little difference in the amount of light between each of the light emitting elements can be obtained. When the mounting portion 9 is provided on the element mounting substrate 7, wiring is provided on the upper surface 7a and/or an inner portion 7c of the element mounting substrate 7. This wiring is connected to a power source.

In the substrate support structure D illustrated in FIGs. 6 and 7, the enclosure member 3 has a rectangular cross-sectional shape, but the enclosure member 3 can also have a chevron shape in cross section as illustrated in FIG. 5.

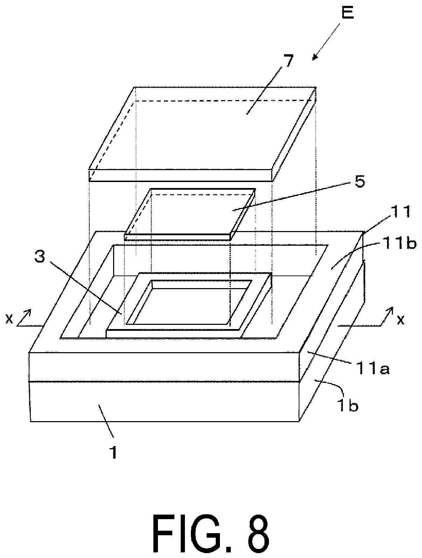

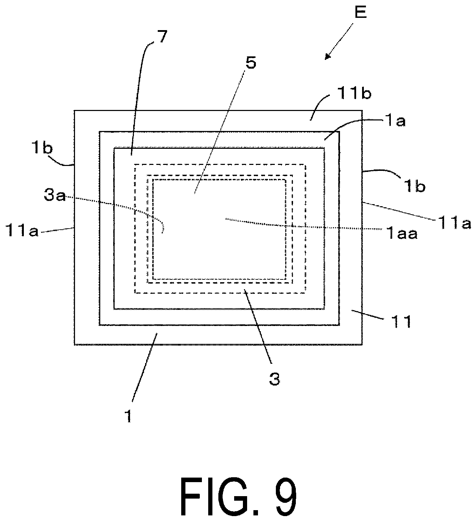

FIG. 8 is an exploded perspective view illustrating another aspect of the substrate support structure. FIG. 9 is a plan view of a substrate support structure E illustrated in FIG. 8.

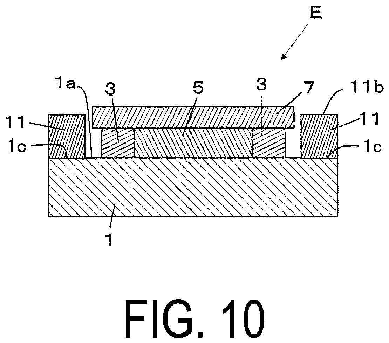

FIG. 10 is a cross-sectional view taken along a line x-x in FIG. 8. The substrate support structure E illustrated in FIGs. 8, 9 and 10 has a frame member 11. The substrate support structure E includes the frame member 11 on the support plate 1.

The frame member 11 is arranged on a peripheral edge portion 1c of the support plate 1. The frame member 11 is positioned around the enclosure member 3, the bonding material 5, and the element mounting substrate 7 that are arranged on the support plate 1. The frame member 11 surrounds the enclosure member 3, the bonding material 5, and the element mounting substrate 7 that are arranged on the support plate 1. According to the substrate support structure E, the frame member 11 is responsible for protecting the enclosure member 3, the bonding material 5, and the element mounting substrate 7 that are arranged in the region inside the frame member 11 on the support plate 1.

For example, when the frame member 11 is provided on the support plate 1, the enclosure member 3, the bonding material 5, and the element mounting substrate 7 can be protected from the physical harm from a direction facing a side surface 11a of the frame member 11. The frame member 11 may be arranged such that the side surface 11a on the outside of the frame member 11 is arranged along a side surface 1b of the support plate 1. The side surface 11a on the outside of the frame member 11 and the side surface 1b of the support plate 1 may be arranged to be flush with each other.

Although not illustrated, a lid may be bonded to the frame member 11. The lid is installed on an upper surface 11b of the frame member 11. The lid is bonded to the entire periphery of the upper surface 11b of the frame member 11. When the lid is provided in the frame member 11, the enclosure member 3, the bonding material 5, and the element mounting substrate 7 can be protected also from the physical harm from a direction facing the upper surface 11b of the frame member 11. Furthermore, a space inside the frame member 11 on the support plate 1 can be hermetically sealed.

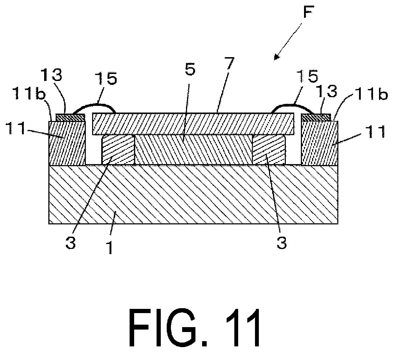

FIG. 11 is a cross-sectional view illustrating another aspect of the substrate support structure. A substrate support structure F illustrated in FIG. 11 includes external electrodes 13 on the upper surface 11b of the frame member 11. When the external electrodes 13 are provided on the upper surface 11b of the frame member 11, electrical connection with the element mounting substrate 7 can be easily performed using, for example, bonding wires 15.

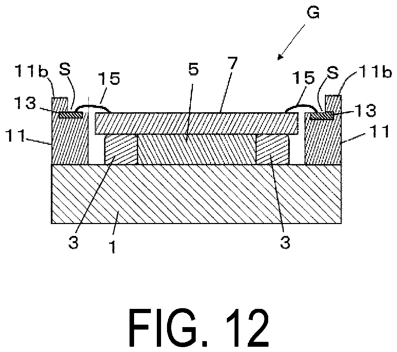

FIG. 12 is a cross-sectional view illustrating another aspect of the substrate support structure. In a substrate support structure G illustrated in FIG. 12, a step portion S is provided on the upper surface 11b of the frame member 11, and the external electrodes 13 are provided on the step portion S. In this case, the external electrode 13 may extend into the frame member 11 and may be integrated with inner layer wiring. The external electrode 13 and the inner layer wiring may be electrically connected via a connection portion.

According to the substrate support structure G, because the wire 15 connected to the element mounting substrate 7 is connected to the external electrode 13 provided in the step portion S of the frame member 11, the position of the wire 15 can be lower than the position of the upper surface 11b of the frame member 11. This makes it possible to protect the enclosure member 3, the bonding material 5, and the element mounting substrate 7. This also makes it possible to minimize the possibility of the physical harm to the wire 15 from an object passing through the upper surface 11b of the frame member 11.

As the enclosure member 3 of each of the substrate support structures E, F, and G provided with the frame member 11, the enclosure member 3 having a rectangular cross section is illustrated as an example. However, the enclosure member 3 having a chevron cross section illustrated in FIG. 5 can also be applied to the enclosure member 3 of each of the substrate support structures E, F, and G.

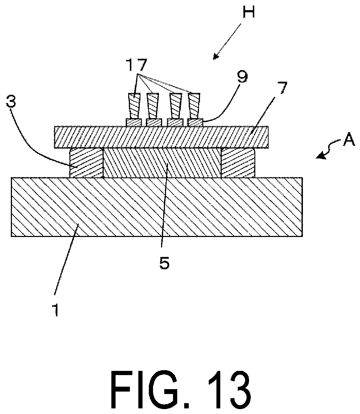

FIG. 13 is a cross-sectional view of a light emitting device illustrated as an example of the embodiment. A light emitting device H illustrated in FIG. 13 has a structure in which the substrate support structure A illustrated in FIGs. 1 to 3 is applied as the substrate support structure, but the substrate support structures B to G described above can also be applied as the substrate support structure.

In the light emitting device H illustrated in FIG. 13, light emitting elements 17 are arranged on the mounting portion 9 of the element mounting substrate 7 included in the substrate support structure A. In this case, the mounting portion 9 includes a plurality of the light emitting elements 17. The plurality of light emitting elements 17 are mounted on the mounting portion 9 of the element mounting substrate 7. According to the light emitting device H, light can be emitted in a direction as designed from an electronic device in which the light emitting device H is installed.

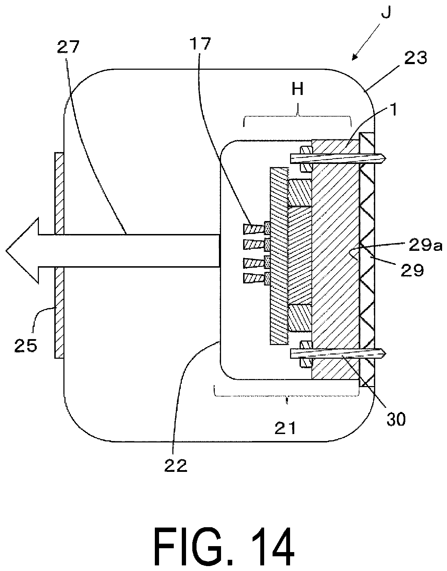

FIG. 14 is a cross-sectional view of a light fixture illustrated as an example of the embodiment. A lighting fixture J includes the light emitting device H as a light source portion 21. The light source portion 21 has a configuration in which the light emitting device H is provided with a lid 22. The lid 22 is formed of a translucent member. The translucent member is preferably made of glass, ceramic, or the like in terms of light transparency and thermal resistance.

The light source portion 21 is provided inside a casing 23. The casing 23 includes a light transmission portion 25. The light transmission portion 25 is arranged facing the direction in which light 27 emitted from the light source portion 21 travels. The lighting fixture J illustrated in FIG. 14 is assumed to be lighting equipment, a headlamp for an automobile, or the like. For example, when the light emitting device H is installed in an electronic device such as a headlamp, the support plate 1 included in the substrate support structure A is fixed to a base 29 attached to the casing 23 of the headlamp (lighting fixture J) by a fixing jig 30.

In the light emitting device H, when the element mounting substrate 7 on which the light emitting elements 17 are mounted is not parallel to the base 29 attached to the casing 23, the traveling direction of the light 27 deviates from the set direction. On the other hand, the substrate support structures A to G and the light emitting device H described above can be installed such that the element mounting substrate 7 on which the light emitting elements 17 are mounted is parallel to the support plate 1.

In the case of the substrate support structures A to G and the light emitting device H, when the support plate 1 is fixed along the surface 29a of the base 29 attached to the casing 23, the element mounting substrate 7 is parallel to a surface 23a of the base 29 attached to the casing 23. In this manner, the traveling direction of the light 27 can be set at a right angle or an angle close to a right angle with respect to a surface 29a of the base 29 attached to the casing 23 of the headlamp (the lighting fixture J).

As a result, lighting fixture J with stable directionality of the light 27 can be obtained. According to the substrate support structures A to G, the light emitting device H, and the lighting fixture J that are described above, even when the plurality of light emitting elements 17 are mounted on the mounting portion 9 of the element mounting substrate 7, any one of the substrate support structures A to G and the support plate 1 are bonded to each other by the bonding material 5 defined to have a surface area and a thickness as designed or close thereto, and thus heat generated from the plurality of light emitting elements 17 can be released from the substrate support structures A to G with little deviation.

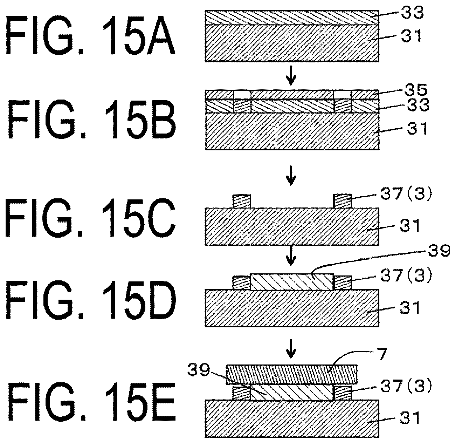

FIG. 15 is a cross-sectional view illustrating a manufacturing method for a substrate support body illustrated as an example of the embodiment. The manufacturing method for the substrate support body illustrated in FIG. 15 is an example in which the substrate support structure A illustrated in FIGs. 1 to 3 is applied to the light emitting device H. As illustrated in FIG. 15A, first, a metal plate 31 serving as the support plate 1 is prepared. Next, a photosensitive resist film 33 is formed on one surface of the metal plate 31. The resist film 33 is mainly composed of an epoxy resin.

Next, as illustrated in FIG. 15B, a mask 35 is placed on the upper surface of the resist film 33, and exposure is performed from above the mask 35. The mask 35 is made of either glass or an organic film. The mask 35 is of a type that allows light to pass through a portion where the resist film is to be cured.

Next, as illustrated in FIG. 15C, development processing is performed on the resist film 33 after exposure. This processing can leave a portion of the resist film 33 that is cured. A portion 37 that is cured becomes the enclosure member 3. The cured part is referred to below as the cured portion 37. The cured portion 37 is the enclosure member 3. The enclosure member 3 formed by the method illustrated in FIG. 15C has a rectangular cross section. A height of the cured portion 37 is adjusted by a thickness of the resist film 33. A width of the cured portion 37 is adjusted by the size (width, surface area) of the portion through which the light passes formed in the mask.

Next, as illustrated in FIG. 15D, a bonding material sheet 39 is arranged between the cured portion 37 (enclosure member 3) formed on the metal plate 31. In this case, the bonding material sheet 39 formed in advance as a film shape is used. The bonding material sheet 39 becomes the bonding material 5 after heating. If the bonding material sheet 39 processed into a film shape is used, the thickness of the bonding material sheet 39 can be easily adjusted to the height of the cured portion 37. Furthermore, variation in the film thickness of the bonding material sheet 39 can be suppressed.

Next, as illustrated in FIG. 15E, the element mounting substrate 7 is placed on the upper surface of the cured portion 37 and the bonding material sheet 39, and a pressure and heat treatment is performed under a predetermined temperature condition. As the element mounting substrate 7, a substrate is used in which, on one surface of the element mounting substrate 7, a metallized film of copper is first formed and then respective plating films of nickel, gold and tin are formed in this order. The copper metallized film formed on the element mounting substrate 7 is arranged in the central region of the surface of the element mounting substrate 7.

The surface area of the copper metallized film formed on the element mounting substrate 7 corresponds to the surface area of the inner region 3a of the enclosure member 3 formed on the support plate 1. Thus, the substrate support structure A can be prepared. When the frame member 11 is formed on the support plate 1, the cured portion 37 of the resist film 33 serving as the enclosure member 3 is formed on the support plate 1, and then the frame member 11 is bonded to the surface of the support plate 1 on which the cured portion 37 is formed.

As the frame member 11, for example, an organic resin sheet containing an epoxy resin as a main component is also suitable. The organic resin sheet and the frame member 11 may be colored. In order to easily absorb light, a black color is preferable. In order to easily reflect light, a white color is preferable. The above-described method is also used when the substrate support structures B, and D to G are prepared.

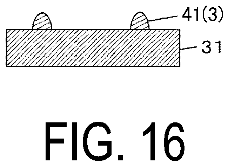

FIG. 16 is a cross-sectional view illustrating a method of forming an enclosure member having a chevron cross-sectional shape. When the substrate support structure C having the enclosure member 3 having a chevron shape in cross section is prepared, as illustrated in FIG. 16, a method is used in which an organic resin material to be the enclosure member 3 is applied to the surface of the metal plate 31 to form a coating film 41.

As a method for forming the coating film 41, a screen printing method is used. Also in this case, the organic resin material contains an epoxy resin as a main component. The organic resin material having a viscosity adjusted to ink-like consistency is used.

The viscosity characteristic of the organic resin material includes thixotropic properties. When an organic resin material having thixotropic viscosity characteristics is used, the shape retention of the coating film 41 formed after printing is enhanced. In this manner, the enclosure member 3 having a chevron shape in cross section can be formed from the coating film 41. The height of the coating film 41 is adjusted by, for example, an interval between the metal plate 31 and the printing screen. The width of the coating film 41 is adjusted by the size (width, surface area) of the opening in the printing screen. Other procedures except for the procedure of forming the coating film 41 to be the enclosure member 3 are roughly the same as those of the manufacturing method illustrated in FIG. 15.

### EXAMPLES

Specifically, the substrate support bodies illustrated in FIGs. 3, 4, 5, and 6 were prepared and evaluated as described below. Sample 1 corresponds to the substrate support structure A illustrated in FIG. 3. Sample 1 was prepared so that the height of the enclosure member was equal to the thickness of the bonding material. Sample 2 corresponds to the substrate support structure B illustrated in FIG. 4. Sample 2 was prepared so that the height of the enclosure member was less than the thickness of the bonding material.

Sample 3 corresponds to the substrate support structure C illustrated in FIG. 5. Sample 3 was prepared so that the shape of the cross section of the enclosure member was a chevron shape and the height thereof was less than the thickness of the bonding material. Sample 4 corresponds to the substrate support structure D illustrated in FIG. 6. In Sample 4, the mounting portion was provided on the element mounting substrate. Sample 5 is a substrate support body prepared without installing an enclosure member.

Sample 1, Sample 2, and Sample 4 were prepared using the manufacturing method illustrated in FIG. 15. Sample 3 was prepared using the manufacturing method illustrated in FIG. 16. In Sample 2 and Sample 3, the difference between the height of the enclosure member and the thickness of the bonding material was 30 µm. In Sample 1 and Sample 4, the difference between the height of the enclosure member and the thickness of the bonding material was 5 µm. Aluminum plate was used as the support plate. As the element mounting substrate, a substrate made of silicon nitride was used in which, on one surface of the substrate, a copper metallized film was formed, and then plating films of nickel, gold, and tin were further formed in this order.

The copper metallized film formed on the element mounting substrate was arranged in the central region of the surface of the element mounting substrate. The surface area of the copper metallized film formed on the element mounting substrate was the same as the surface area of the inner region of the enclosure member formed on the support plate. Au-Sn was used as the bonding material. The elastic modulus at room temperature (25°C) was about 1 GPa for the resist film (epoxy resin) used as the enclosure member, about 60 GPa for Au-Sn, and about 200 GPa for the element mounting substrate.

The samples were prepared by preparing a mother sample in which 25 samples were arranged in a matrix and cutting the mother sample into individual pieces. For each sample size, the support plate was 20 mm × 30 mm and 0.5 mm thick. The width of the enclosure member was 1 mm. The length of the enclosure member was 50 mm for the entire circumference (10 mm + 10 mm + 15 mm + 15 mm).

The size of the element mounting substrate was 15 mm × 20 mm. The surface area of the mounting portion of the light emitting element formed on the upper surface of the element mounting substrate was 10 mm × 15 mm. The light emitting elements were mounted on the mounting portion at a 5 mm pitch. The number of light emitting elements mounted on the mounting portion was six (two rows and three columns).

Next, the temperature of the surface of the element mounting substrate when a voltage was applied to the light emitting element for 1 minute was measured using a thermocouple. The number of samples used for evaluation was 10 in each case, and the average value was determined. The number of samples used for measuring the temperature of the surface of the element mounting substrate was one. In Table 1, "Surface temperature of element mounting substrate when light emitting elements are driven" is illustrated. In this case, the lower the surface temperature of the element mounting substrate is, the larger the amount of heat discharge from the element mounting substrate through the bonding material and the support plate is.

Next, the prepared samples were evaluated as illustrated in Table 1. First, the ratio of the wet area of the bonding material to the surface area of the copper metallized film formed on the element mounting substrate was determined. In Table 1, "Wet area of bonding material/surface area of copper metallized film" is illustrated. Next, the wet area of the bonding material was determined based on the surface area of the inner region of the enclosure member formed on the support plate. In Table 1, "Wet area of bonding material/surface area of inner region of enclosure member" is illustrated.

Here, the wet area is a surface area in which the bonding material (eutectic solder) adheres to the copper metallized film formed on the element mounting substrate. In Table 1, a negative value indicates that the wet area of the bonding material is less than the surface area of the copper metallized film. A positive value indicates that the wet area of the bonding material is greater than the surface area of the copper metallized film. A value of 0 indicates that the wet area of the bonding material is within 1% of the surface area of the copper metallized film.

The wet area was determined from the image obtained using the X-ray CT. Specifically, the X-Y direction of the copper metallized film formed on the element mounting substrate was photographed as a plane, and the ratio of the surface area to which the bonding material adhered to the surface area of the copper metallized film in the X-Y direction was calculated.

Next, the change in the thickness of the bonding material was determined. In this case, the change in the thicknesses of the bonding material corresponds to a ratio ((t2 - t1)/t1), which is a ratio of the thicknesses t2 of the bonding materials after the substrate support structure is prepared to the thicknesses of the bonding material sheets used as a reference (t1). The thicknesses t2 of the bonding material after preparing the substrate support structure is obtained by measuring three portions existing in the inner region of the enclosure member.

The thickness of the bonding material was determined by polishing the cross section of the prepared substrate support structure, then taking a photograph of the cross section, and obtaining the thickness from the taken photograph. The digital microscope was used to capture photographs. The variation in the thickness of the bonding material was determined to be a value obtained by dividing the difference between the maximum value and the minimum value of the thickness obtained from the measured 10 samples by the average value.

The presence or absence of spreading of the bonding material from the range of the enclosure member was evaluated from the state of the surface of the element mounting substrate by observing the substrate support structure with the naked eye from a direction facing the side surface. In Table 1, the expression "Present (small)" indicates a state in which the width of the bonding material spread to the same extent as the width of the enclosure member. In Sample 5, although the enclosure member was not used, the state described as "Present (large)" is a state in which the width of the bonding material spread by 5 times or more the width of the enclosure member used in each of Samples 1 to 4.

In each of Sample 1 to Sample 4, the bonding material was in contact with a portion from the side surface facing the inner region of the enclosure member to the apex portion of the enclosure member. The presence or absence of a crack generated in the bonding material was also evaluated using X-ray CT.

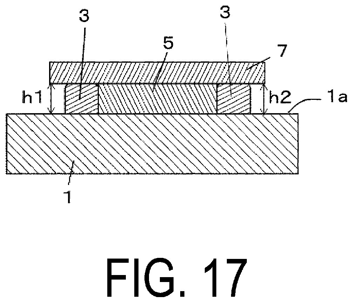

The parallelism was determined from the difference of intervals between the support plate and the element mounting substrate by the method illustrated in FIG. 17 for the prepared substrate support structure. The parallelism was determined to be higher as the difference between h1 and h2 (h1 - h2) was closer to 0.

**[Table 1]**

| Sample number | Target figure | Wet area of bonding material/ surface area of copper metallized film | Wet area of bonding material/ surface area of inner region of enclosure member | Change rate of thickness of bonding material | Presence or absence of spreading of bonding material from range of enclosure member | Presence or absence of crack generated in bonding material | Surface temperature of element mounting substrate when light emitting elements are driven | Difference (parallelism) of intervals between support plate and element mounting substrate |
|---|---|---|---|---|---|---|---|---|
| Sample 1 | FIG. 3 | 0.92 | 0.98 | -0.05 | Absent | Absent | 110°C | 0.8 µm |
| Sample 2 | FIG. 4 | 0.95 | 1.06 | -0.05 | Present (small) | Absent | 105°C | 0.9 µm |
| Sample 3 | FIG. 5 | 0.95 | 1.1 | -0.05 | Present (small) | Absent | 95°C | 1.0 µm |
| Sample 4 | FIG. 6 | 0.95 | 1.06 | -0.05 | Present (small) | Absent | 95°C | 0.8 µm |
| Sample 5 | - | 0.85 | 1.3 | -0.3 | Present (large) | Present | 112°C | 1.9 µm |

As is clear from Table 1, in the samples (Samples 1 to 4) provided with the enclosure member, the ratio of the wet area of the bonding material to the surface area of the copper metallized film was large and the surface area where the bonding material wetted and adhered to the surface of the copper metallized film was large compared to the sample (Sample 5) not provided with the enclosure member. In addition, the ratio of the wet area of the bonding material to the surface area of the inner region of the enclosure member was small, and the bonding material was difficult to spread by the enclosure member.

In addition, the amount of change in the thickness of the bonding material with respect to the thickness of the bonding material sheet was small, and the system for the thickness of the bonding material was high. In addition, in Samples 1 to 4, no crack was observed in the bonding material. In addition, in Samples 1 to 4, the surface temperature of the element mounting substrate when the light emitting elements were driven was less than that of Sample 5.

In addition, in Sample 2 in which the height of the enclosure member from the support plate was lower than the position of the upper surface of the bonding material, both the ratio of the wet area of the bonding material to the surface area of the copper metallized film and the ratio of the wet area of the bonding material to the surface area of the inner region of the enclosure member were greater than those in Sample 1 in which the height of the enclosure member from the support plate was the same as and/or similar to the position of the upper surface of the bonding material.

In addition, the surface temperature of the element mounting substrate when the light emitting elements were driven was less in Sample 2 than in Sample 1. In addition, when the difference of the intervals between the support plate and the element mounting substrate was measured, the difference was 1.0 µm or less in Samples 1 to 4 but was as large as 1.9 µm in Sample 5. Samples 1 to 4 had greater parallelism than Sample 5.

### REFERENCE SIGNS

A to G Substrate support structure
A1, B1, C1, D1 Substrate support body
J Lighting fixture
H Light emitting device
1 Support plate
3 Enclosure member
3a Inner region
5 Bonding material
7 Element mounting substrate
9 Mounting portion
21 Light source portion
23 Casing
25 Light transmission portion

## Claims

1. A substrate support body comprising:
a support plate;
an enclosure member; and
a bonding material, wherein
the enclosure member is arranged on the support plate, and
the bonding material is arranged on an entire surface of an inner region of the enclosure member and is bonded to the support plate.

2. The substrate support body of claim 1, wherein
a position of an upper surface of the enclosure member is lower than a position of an upper surface of the bonding material.

3. The substrate support body according to claim 2, wherein
a difference between a height of the enclosure member and a thickness of the bonding material is 5 µm or more and 30 µm or less.

4. The substrate support body according to any one of claims 1 to 3, wherein
the bonding material is in contact with a portion from a side surface of the enclosure member facing the inner region of the enclosure member to an apex portion of the enclosure member.

5. The substrate support body according to any one of claims 1 to 4, wherein
the enclosure member includes a portion forming a convex curved surface from a side surface of the enclosure member facing the inner region of the enclosure member to an apex portion of the enclosure member.

6. The substrate support body according to any one of claims 1 to 5, wherein
an elastic modulus of the enclosure member is less than an elastic modulus of the bonding material.

7. A substrate support structure comprising:
an element mounting substrate arranged on the substrate support body according to any one of claims 1 to 6.

8. The substrate support structure according to claim 7, wherein
an elastic modulus of the enclosure member and an elastic modulus of the bonding material are less than an elastic modulus of the element mounting substrate.

9. The substrate support structure according to claim 7 or 8, wherein
a surface area of a main surface of the element mounting substrate is greater than a surface area of a region surrounded by an outer peripheral edge of the enclosure member.

10. The substrate support structure according to any one of claims 7 to 9, wherein
the element mounting substrate includes, on a first surface of the element mounting substrate opposite to a second surface of the element mounting substrate proximate to the bonding material, a mounting portion configured to mount a plurality of light emitting elements, and
a surface area of the mounting portion on the first surface of the element mounting substrate is less than a surface area of the bonding material in a direction identical to a direction along the first surface.

11. A light emitting device comprising:
a light emitting element provided on the substrate support structure according to any one of claims 7 to 10.

12. A lighting fixture comprising:
a light source portion including the light emitting device according to claim 11, the light source portion being provided inside a casing, the casing including a light transmission portion.
